# EUROPEAN PATENT APPLICATION

(11) **EP 1 827 064 A1**
(43) Date of publication of application: **29.08.2007**
(21) Application number: 05799990.6
(22) Date of filing: 02.11.2005
(51) Int. Cl.: H05K 1/16, H01G 4/12

(54) **CAPACITOR LAYER FORMING MATERIAL, AND PRINTED WIRING BOARD HAVING INTERNAL CAPACITOR LAYER OBTAINED BY USING SUCH CAPACITOR LAYER FORMING MATERIAL**

(30) Priority: 04.11.2004 JP 2004321298
(71) Applicant: MITSUI MINING & SMELTING CO., LTD., Tokyo 141-8584 (JP)
(72) Inventor: KANNO, A., c/o MITSUI MINING & SMELTING CO., LTD, Ageo-shi, Saitama 362-0021 (JP); ABE, N., c/o MITSUI MINING & SMELTING CO., LTD, Ageo-shi, Saitama 362-0021 (JP); SUGIOKA, A., c/o MITSUI MINING & SMELTING CO., LTD, Ageo-shi, Saitama 362-0021 (JP); MASHIKO, Y., c/o MITSUI MINING & SMELTING CO., LTD, Ageo-shi, Saitama 362-0021 (JP)
(74) Representative: Bohmann, Armin K.
(86) International application number: PCT/JP2005/020183
(87) International publication number: WO 2006/049195

(57) **Abstract**

It is an object of the present invention to provide a capacitor layer forming material which is applicable to printed wiring boards manufactured through a high-temperature processing of 300°C to 400°C of a fluorine-contained resin substrate, a liquid crystal polymer and the like, and exhibits no deterioration of the strength after a high-temperature heating. In order to achieve the object, a capacitor layer forming material for a printed wiring board which comprises a first conductive layer used for forming a top electrode, a second conductive layer used for forming a bottom electrode and a dielectric layer between the first and second conductive layers, **characterized in that** for the second conductive layer, a nickel layer or a nickel alloy layer is employed. The nickel layer or the nickel alloy layer as the second conductive layer preferably has a thickness of 10 micron meter to 100 micron meter. Further, the sol-gel method is suitably employed to form the dielectric layer on the nickel layer or the nickel alloy layer constituting the second conductive layer.

## Description

### Technical Field

The invention according to the present application relates to a capacitor layer forming material and a printed wiring board having an embedded capacitor layer obtained by using the capacitor layer forming material.

### Background Art

Multi-layer printed wiring boards embedding capacitor circuits (elements) use at least one layer of insulating layers located at inner layers of the boards as dielectric layers. As disclosed in Patent Document 1, a capacitor circuit is formed by oppositely arranging a top electrode and a bottom electrode as a capacitor in inner-layer circuits located on both surfaces of the dielectric layer, and used as an embedded capacitor. For forming the capacitor circuit, a capacitor layer forming material having a layer constitution of a first conductive layer/a dielectric layer/a second conductive layer, which is similar to a double-sided copper-clad laminate, is commonly used. Manufacturing of embedded capacitor circuits employ various methods such as a method in which a conductive layer of a capacitor layer forming material is previously etched to form a capacitor circuit and the capacitor layer forming material is laminated on an inner-layer substrate or a method in which a capacitor layer forming material is etched after laminated on an inner-layer substrate.

As capacitors made saving of the electronic power in electric devices possible through accumulating excess electricity, so the capacitors are required to have the largest possible electric capacity as a fundamental quality. The capacity of a capacitor is calculated from the equation: C = εε₀ (A/d) (ε₀ is the dielectric constant in vacuum) . Especially, the recent tendency of down sizing of electronic and electric devices requires printed wiring boards to have the capacity also; however, occupation of large areas for capacitor electrodes in certain areas of printed wiring boards is almost impossible, so improvements by the surface area (A) obviously have a limitation. Therefore, for increasing the capacitor capacity, with a constant surface area (A) of a capacitor electrode and a constant specific dielectric constant (e) of a dielectric layer, attempts have been made in which the thickness (d) of a dielectric layer is made to be thin or layer configurations are devised in view of the capacitor circuit as a whole.

On the other hand, as for formation of the dielectric layer, various manufacturing methods using a metal foil involving a method in which a resin composition containing a dielectric filler is coated on the surface of a metal foil as disclosed in Patent Document 2, a method in which a film containing a dielectric filler is laminated on the surface of a metal foil as disclosed in Patent Document 3 and a sol-gel method in which the chemical vapor reaction method is applied to the surface of a copper/nickel-phosphorus alloy composite-layered electrode material as disclosed in Patent Document 4 have been employed. Among them, the sol-gel method is especially excellent from the viewpoint of forming a thin dielectric layer.

In recent years, highly integrated IC chips and high-speed signal transmission focusing the range from giga Hz levels to tera Hz levels are required; the heat generation in printed wiring boards may become large; and many high frequency properties are required. For responding to these requirements, printed wiring boards composed of a fluorine-contained resin, a liquid crystal polymer, etc. as a substrate material is extensively being manufactured as disclosed in Patent Document 5 and Patent Document 6.

[Patent Document 1] Japanese Patent Laid-Open No. 2003-105205
[Patent Document 2] Japanese Patent Laid-Open No. H9-040933
[Patent Document 3] Japanese Patent Laid-Open No. 2004-250687
[Patent Document 4] U.S. Patent No. 6541137
[Patent Document 5] Japanese Patent Laid-Open No. 2003-171480
[Patent Document 6] Japanese Patent Laid-Open No. 2003-124580

However, with consideration that the capacitor layer-forming material has a layer constitution of a first conductive layer/a dielectric layer/a second conductive layer, making the dielectric layer thin results in making the thickness of the capacitor layer forming material itself to be thin. It may cause drawbacks of difficulty in maintaining the strength, having a higher possibility of suffering damage such as fracture on handling and lacking safety in handling.

If a capacitor circuit is formed by employing two or more kinds of metals for a conductive layer of a capacitor layer forming material and etching-process is employed for forming the conductive layer as disclosed in Patent Document 4, there arises a problem that etching of a fine capacitor circuit shape is impossible due to the difference in the etching rates of the two or more kinds of metals. Further, when a material obtained by multi-layered metals of two or more kinds (especially in the material having a lamination structure of a nickel-phosphorus alloy and copper) as a constitution material of an electrode material is used, it brings a phenomenon that a chemical element which inhibits the adhesion with dielectric layer diffuses between the electrode and a dielectric layer and deteriorates the adhesion due to a thermal history in a sol-gel film formation.

Further, when a dielectric layer is formed by the sol-gel method as disclosed in Patent Document 4, a sol-gel film for forming a dielectric layer is formed on the surface of a metal foil and baking at a temperature of about 600°C is required, so a phenomenon that the metal foil tends to be brittle due to oxidation has been caused. Additionally, when a nickel-phosphorus alloy layer is provided as the surface of a bottom electrode, there arises a problem in the adhesion between the dielectric layer and the electrode-constituting material and a phenomenon of peeling between the dielectric layer and the electrode-constituting material has been happened. Then, it results unsatisfied designated quality because of a large deviation from the designated electric capacity as a capacitor. The peeling may be a trigger for generating of the delamination in a printed wiring board, for causing the interlayer delamination by being subjected to heat shock such as solder reflow and for shortening the product life due to delamination induced by heat generation during the operation.

On the other hand, inplaceofconventionalglass-epoxysubstrates, manufactures of multi-layered substrates are being attempted using fluorine-contained resin substrates, liquid crystal polymers and the like as a substrate material in consideration of high-temperature thermal resistance, high-frequency properties and the like. Items common to these substrate manufactures are the press-processing temperature, which is as very high as from 300°C to 400°C, and the point that the substrate materials are hard. Therefore, in the case of forming an embedded capacitor layer in a multi-layer printed wiring board using the fluorine-contained resin substrate, the liquid crystal polymer, etc. as a substrate material, the embedded capacitor layer desirably has no fluctuation in material properties although it undergoes a high-temperature press-process of 300°C to 400°C and is pressed by a hard substrate material, and desirably has a strength enough to withstand the expansion and contraction of the surrounding materials.

Accordingly, capacitor layer forming materials with a bottom electrode of a capacitor circuit which have a stable adhesion with a dielectric layer and formation of a fine capacitor circuit shape is possible, and also exhibit no deterioration of the strength even after a high- temperature processing of 300°C to 400°C in forming a printed wiring board formed with a fluorine-contained resin, a liquid crystal polymer, or the like as a substrate material have been demanded in the markets.

### Disclosure of the Invention

Then, as a result of extensive studies, the present inventors have acquired an idea that use of a capacitor layer forming material described hereinafter provides a favorable adhesion between a dielectric layer and a bottom electrode and enhances the ability in handling while keeping the strength of the capacitor layer forming material even if the dielectric layer is thin. Additionally, the capacitor layer forming material does not deteriorate strength after processing in a high-temperature of 300°C to 400°C as a printed wiring board constituted from a fluorine-contained resin substrate, a liquid crystal polymer, etc. as a substrate material, and use of the capacitor layer forming material described later securely improves the electric capacity as a capacitor circuit.

### <Capacitor layer forming materials according to the present invention>

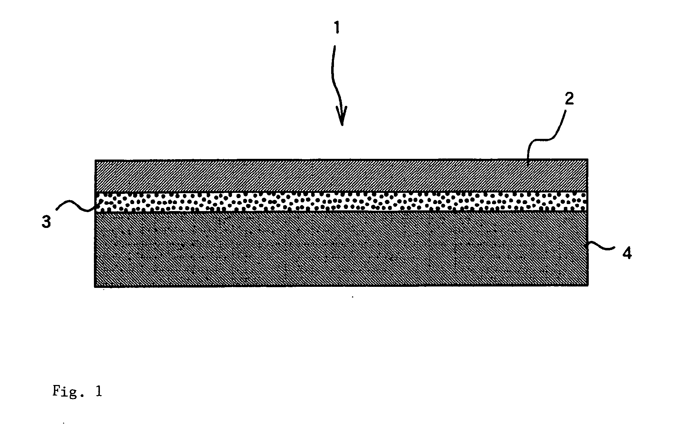

Figure 1 shows an illustrative cross-section of a capacitor layer forming material. As is clear from Figure 1, a capacitor layer forming material 1 comprises a first conductive layer 2 to be used for forming an top electrode, a second conductive layer 4 to be used for forming a bottom electrode and a dielectric layer-3 between the first and second conductive layers. The capacitor layer forming material according to the present invention is characterized by using a single layer of nickel or a nickel alloy as the second conductive layer 4 to be used for forming a bottom electrode.

In the capacitor layer forming material according to the present invention, the nickel layer or the nickel alloy layer as the second conductive layer has a thickness of preferably 10 micron meter to 100 micron meter.

A nickel foil or a nickel alloy foil manufactured by the rolling method or electrolysis method is preferably used for the second conductive layer.

Further in the capacitor layer forming material according to the present invention, the dielectric layer is preferably formed by the sol-gel method on the nickel layer or nickel alloy layer constituting the second conductive layer.

In the case of using a nickel alloy layer as the second conductive layer of the capacitor layer forming material according to the present invention, a nickel-phosphorus alloy or a nickel-cobalt alloy is preferably used.

### <Printed wiring boards having an embedded capacitor circuit>

Printed wiring boards having an embedded capacitor circuit can be manufactured by using any one of the capacitor layer forming materials according to the present invention by various methods. The capacitor circuit embedded in the printed wiring boards thus manufactured do not generate no abnormality on a bottom electrode shape although the capacitor circuit undergoes repeatedly the hot press-processes of 300°C to 400°C because the second conductive layer constituting the bottom electrode is composed of the composite foil excellent in a high-temperature thermal resistance, and has a resistance against the expansion and contraction behavior of surrounding materials by heating. Therefore, the capacitor layer forming material is suitable for forming an embedded capacitor circuit of a multi-layer printed wiring board using a fluorine-contained resin substrate or liquid crystal polymer substrate. The printed wiring board described in the present invention means ones including products such as mother boards of computers and products including small package substrates to directly mount IC chips on, etc...

The capacitor layer forming material according to the present invention generates no abnormality in the bottom electrode shape also after formation of the capacitor circuit shape although undergoing repeatedly the hot press-processes of 300°C to 400°C applied for manufacturing multi-layer printed wiring boards using a fluorine-contained resin substrate or liquid crystal polymer substrate because the second conductive layer constituting the bottom electrode is composed of a nickel layer or nickel alloy layer excellent in a high-temperature thermal resistance, and has a resistance against the expansion and contraction behavior of surrounding materials by heating.
Moreover, the capacitor layer forming material enables the adhesion between the second conductive layer and the dielectric layer to be well maintained. Consequently, also the printed wiring board having the embedded capacitor circuit obtained by using the capacitor layer forming material according to the present invention is made to be of a high quality.

### Brief Description of the Drawings

Figure 1 is an illustrative sectional view of a capacitor layer forming material according to the present invention;
Figure 2 is an illustrative view showing a manufacturing flow of a printed wiring board having an embedded capacitor circuit using a capacitor layer forming material according to the present invention;
Figure 3 is an illustrative view showing a manufacturing flow of a printed wiring board having an embedded capacitor circuit using a capacitor layer forming material according to the present invention;
Figure 4 is an illustrative view showing a manufacturing flow of a printed wiring board having an embedded capacitor circuit using a capacitor layer forming material according to the present invention; and
Figure 5 is an illustrative view showing a manufacturing flow of a printed wiring board having an embedded capacitor circuit using a capacitor layer forming material according to the present invention.

### Description of Symbols

- 1: capacitor layer forming material
- 2: first conductive layer
- 3: dielectric layer
- 4: - second conductive layer
- 5: top electrode
- 6: copper foil layer
- 7: semicured resin layer
- 7': insulating layer
- 8: resin coated copper foil
- 9: bottom electrode
- 10: printed wiring board
- 21: etching resist layer
- 22: outer layer circuit
- 23: via hole
- 24: copper plated layer

### Best Mode for Carrying Out the Invention

Hereinafter, embodiments of manufacturing metal foils to form a nickel layer or nickel alloy layer according to the present invention will be described; embodiments of manufacturing the capacitor layer forming material according to the present invention will be described; and manufacture up to a printed wiring board having an embedded capacitor circuit will be described in the examples.

### <A material for forming a second conductive layer (nickel layer or nickel alloy layer)>

Employment of a nickel layer or nickel alloy layer as a second conductive layer in the present invention is for four reasons as follows . (1) The nickel layer or nickel alloy layer is available as a metal foil, and a dielectric layer can be formed on the surface of the foil as it is by the sol-gel method. (2) The foil is excellent in oxidation resistance and softening resistance against the severe thermal history in the dielectric layer formation by the sol-gel method. (3) The adhesion with the dielectric layer can be controlled at a certain level by arranging the nickel alloy composition. (4) Employing the metal layer of a single component allows formation of a fine capacitor circuit when the bottom electrode shape is formed by etching.

The nickel layer or nickel alloy layer herein described is intended to use mainly a metal foil. Therefore, the nickel layer is a layer formed of a pure nickel foil of not less than 99.9% in purity (the balance is inevitable impurities) . The nickel alloy layer is a layer formed by using a nickel-phosphorus alloy. The content of phosphorus in the nickel phosphorus alloy is preferably 0.1 to 11 wt%. The phosphorus component of the nickel-phosphorus alloy layer is suspected to diffuse into the dielectric layer to deteriorate the adhesion with the dielectric layer and change the dielectric constant if it was subjected to a high temperature in manufacture of a capacitor layer forming material and in a conventional manufacturing process of a printed wiring board. However, the nickel-phosphorus alloy layer having appropriate phosphorus content improves the electric characteristics as a capacitor. With the phosphorus content of less than 0. 1 wt%, the nickel-phosphorus alloy layer has no difference from the pure nickel and loses the importance of alloying. By contrast, with the phosphorus content exceeding 11 wt%, phosphorus segregates on the interface of the dielectric layer and deteriorates the adhesion with the dielectric layer, and the interface is easily delaminate. Therefore, the phosphorus content is preferably in the range from 0.1 wt% to 11 wt%. For securing a stable adhesion with the dielectric layer, the phosphorus content in the range from 0.2 wt% to 3 wt% allows a capacitor circuit in a stable quality to be formed even with certain dispersion in process. Positively pointing out the optimum range, the phosphorus content of 0.25 wt% to 1 wt% secures the most favorable adhesion with the dielectric layer and also the favorable dielectric constant. The nickel content in the present invention is a value in terms of [P component weight]/ [Ni component weight] × 100 (wt %).

The nickel foil and nickel alloy foil herein listed are excellent in thermal resistance, and even if subj ected to heating at approximately 400°C for 10 hrs, it is hard to become soft and can effectively suppress a decrease in tensile strength as a whole composite foil and maintain a tensile strength after the heating at not less than 50 kgf/mm². By contrast, when a composite material in which a nickel layer and a copper layer are laminated is used as a material constituting the second conductive layer and subjected to loading a temperature exceeding 400°C, diffusion within the nickel layer and the copper layer occur, so the nickel layer itself cannot maintain the softening resistance, and the toughness as the capacitor forming material decreases to cause poor ability in handling.

As long as the nickel foil or nickel alloy foil has such properties, a printed wiring board formed therefrom and containing a fluorine-contained resin, liquid crystal polymer, or the like as a substrate material exhibits almost no deterioration of the strength even after a high-temperature processing of 300°C to 400°C, indicating almost no quality deterioration of the capacitor layer forming material using the metal foil for the second conductive layer. The crystal structure of the nickel foil and nickel alloy foil according to the present invention preferably has finest possible crystal grains so as to make its strength improved. More specifically, the crystal structure has an average grain size preferably at a fine level of not more than 0.5 micron meter and a physical property of high mechanical strength.

The thickness of the nickel layer or the nickel alloy layer is preferably 10 micron meter to 100 micron meter. With the thickness of less than 10 micron meter, the layer remarkably lacks the ability in handling as a metal foil, and formation of a dielectric layer on the surface of the foil becomes very difficult. The nickel layer or the nickel alloy layer used for constituting the second conductive layer may be utilized for resistance circuits and the like, with the thickness of less than 10 micron meter, utilization may be difficult.

The nickel foil or the nickel alloy foil used for constituting the second conductive layer described above can be one manufactured by the electrolysis method or the rolling method. These manufacturing methods are not especially limited. Especially, the rolling method involves controlling the components of ingots in a metallurgical process and processing the ingots into foils by a rolling mill while subj ecting to an appropriate annealing process, and can sufficiently employ conventional means.

On the other hand, the electrolysis method provides deposits having different metallographic structures depending on the electrolytic solution, electrolysis condition and the like, and it influences on physical strengths as a result. However, to form a nickel layer, any of solutions known as nickel plating solutions can be used. The examples include (i) using nickel sulfate, and conditions of a nickel concentration of 5 to 30 g/l, a solution temperature of 20 to 50°C, pH of 2 to 4 and a current density of 0.3 to 10 A/dm², (ii) using nickel sulfate, and conditions of a nickel concentration of 5 to 30 g/l, potassium pyrophosphate of 50 to 500 g/l, a solution temperature of 20 to 50°C, pH of 8 to 11 and a current density of 0.3 to 10 A/dm², (iii) using nickel sulfate, and conditions of a nickel concentration of 10 to 70 g/l, boric acid of 20 to 60 g/l, a solution temperature of 20 to 50°C, pH of 2 to 4 and a current density of 1 to 50 A/dm², and popular Watts bath conditions etc..

For manufacturing a nickel-phosphorus alloy foil by the electrolysis method, a phosphoric acid based solution is used as an electrolytic solution. This case employs (i) conditions of a nickel sulfate concentration of 120 g/l to 180 g/l, a nickel chloride concentration of 35 g/l to 55 g/l, a H₃PO₄ concentration of 3 g/l to 5 g/l, a H₃PO₃ concentration of 2 g/l to 4 g/l, a solution temperature of 70°C to 95°C, pH of 0.5 to 1.5, and a current density of 5 A/dm² to 50 A/dm², (ii) conditions of a nickel sulfate concentration of 180 g/l to 280 g/l, a nickel chloride concentration of 30 g/l to 50 g/l, H₃BO₃ concentration of 16 g/l to 25 g/l, a H₃PO₃ concentration of 1 g/l to 5 g/l, a solution temperature of 45°C to 65°C and a current density of 5 A/dm² to 50 A/dm², and the like. A nickel-phosphorus alloy layer may be formed by the electroless method using commercial electroless plating solutions, but the method does not satisfy the industrial productivity in point of the film forming rate.

### <An embodiment for manufacturing a capacitor layer forming material according to the present invention>

A method for manufacturing a capacitor layer forming material according to the present invention involves forming a dielectric layer on the surface of the nickel foil or nickel alloy foil. The material of the dielectric layer is not especially limited. The method for forming the dielectric layer can also include various known methods such as a so-called sol-gel method, a coating method in which a dielectric layer is formed by coating of a dielectric filler-containing resin solution which contains a dielectric filler and a binder resin, and a method in which a film containing a dielectric filler is laminated. However, the significance of using the nickel foil or nickel alloy foil for the second conductive layer as in the present invention lies in the expectation of excellent thermal resistance, softening resistance and the like including not causing useless oxidation when the dielectric layer is formed by the sol-gel method, which has many heating processes.

After the formation of the dielectric layer is finished, a first conductive layer to form a top electrode is formed on the dielectric layer. The formation of the first conductive layer on the dielectric layer can employ various known methods such as a lamination method using a metal foil, a method of forming a conductive layer by plating, and a method of sputtering deposition.

### <An embodiment for manufacturing a printed wiring board having an embedded capacitor circuit obtained by using the capacitor layer forming material according to the present invention>

Use of the capacitor layer forming material according to the present invention described above allows formation of a bottom electrode excellent in the adhesion with a dielectric layer. Since the bottom electrode is made of a material excellent in thermal resistance, the bottom electrode does not generate the oxidation degradation and hardly changes in physical properties although undergoing the hot press-processes of several times in the range from 300°C to 400°C. A method for manufacturing a printed wiring board having an embedded capacitor circuit using the capacitor layer forming material according to the present invention is not especially limited, and can employ every method. However, it is preferable, as shown in the following examples, that a method for manufacturing a printed wiring board be employed, the method which can remove the excess dielectric layer other than a portion where an embedded capacitor circuit is formed as much as possible.

### [Example 1]

In Example 1, a first composite foil provided with a nickel layer was manufactured; a capacitor layer forming material was manufactured using the first composite foil; and further a printed wiring board having an embedded capacitor circuit was manufactured.

### <Manufacture of a nickel foil>

A nickel foil of 20 micron meter in thickness was manufactured by depositing nickel on a cathode electrode using the following electrolytic solution and electrolytic conditions followed by peeling off the deposited nickel. The thickness used in the present specification means a thickness based on a plated weight when a different metal layer of a predetermined thickness is formed on a flat surface by plating, and the thickness of a nickel foil actually manufactured is a thickness denoted as a gauge thickness. Meaning of the thicknesses in the following examples and comparative examples is the same.

| (A composition of a nickel electrolytic bath) | |
|---|---|
| NiSO₄.6H₂O: | 240 g/l |
| NiCl₂.6H₂O: | 45 g/l |
| H₃BO₃: | 30 g/l |

| (Electrolysis conditions) | |
|---|---|
| bath temperature: | 50°C |
| pH: | 4.5 |
| current density: | 5 A/dm² |
| anode: | nickel plate |
| cathode: | titanium plate |

Tensile strength and elongation as received and tensile strength and elongation after heating in vacuum at 400°C for 10 hrs was evaluated on the obtained nickel foil. The results are shown in Table 1. The measurements of tensile strength and elongation were conducted according to the measurement of a copper foil for a printed wiring board prescribed in IPC-TM-650 prescribed in IPC-MF-150F. Hereinafter, the measurements were conducted similarly.

### <Manufacture of a capacitor layer forming material>

The above-mentioned nickel foil was used for forming a second conductive layer of a capacitor layer forming material used for forming a bottom electrode, and a dielectric layer was formed on the surface of the nickel foil by the sol-gel method. The nickel foil before forming the dielectric layer by the sol-gel method was subjected to heating at 250°C for 15 min. and ultraviolet ray was irradiated for 1 min. as a pretreatment. In following examples and comparative examples, the heating and the irradiation were performed similarly.

The sol-gel method used herein used a sol-gel solution which was prepared by adding ethanolamine as a stabilizer to methanol heated at nearly its boiling point such that the concentration of ethanolamine to be 50 mol% to 60 mol% of the total metal amount, then titanium isopropoxide and zirconium propoxide as propanol solution, lead acetate, lanthanum acetate and nitric acid as a catalyst was added thereto, and finally the solution was diluted with methanol to be a concentration of 0.2 mol/1. Then, the sol-gel solution was coated on the surface of the nickel foil by a spin coater, dried in the ambient air atmosphere at 250°C for 5 min. , and thermally decomposed in the ambient air atmosphere at 500°C for 15 min. Further, this coating process was repeated for six times to control the film thickness. The resultant coated film was finally baked in a nitrogen-substituted atmosphere at 600°C for 30 min. to form a dielectric layer. The composition ratio of the dielectric layer was Pb: La: Zr: Ti = 1.1:0.05:0.52:0.48 and the nickel foil itself did not exhibit any abnormality.

On the dielectric layer formed as described above, a copper layer of 3 micron meter in thickness as a first conductive layer was formed by the sputtering deposition method to finish a capacitor layer forming material in which the first conductive layer and the second conductive layer are provided on both sides of the dielectric layer. At this stage, a predetermined voltage was imparted to conduct the interlayer dielectric strength measurement, but no short-circuit phenomenon between the first conductive layer and the second conductive layer was found.

To examine the adhesion between the second conductive layer and the dielectric layer, peel strength at the interface between the second conductive layer and the dielectric layer was measured. As a result, peel strength was 50 gf/cm, and is a higher value than those of the comparative examples below. In the case of the electrode area of the top electrode of 1 mm², the average capacitance density exhibited a very favorable value of 284 nF/cm²; the dielectric loss was 2%; thus, it can be said that a favorable capacitor circuit having a favorable electric capacity and a low dielectric loss was obtained.

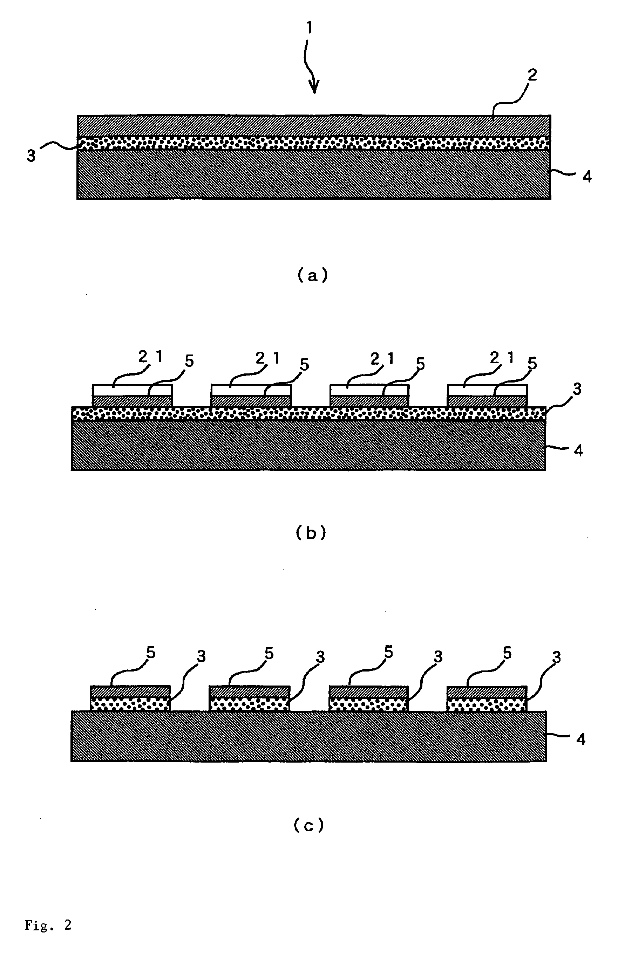

Manufacturing of a printed wiring board: The first conductive layer 2 of one side of the capacitor layer forming material 1 thus manufactured shown in Figure 2(a) was polished, and dry films were laminated on both sides to form an etching resist layer 21. Then, an etching pattern to form a top electrode was exposed on the etching resist layer of the surface of the first conductive layer, and developed. Then, the first conductive layer was etched with a copper chloride etching solution to form top electrodes 5 as shown in Figure 2(b).

Then, after the formation of the top electrodes 5, exposed dielectric layer in the region except the circuit portion was removed with the etching resist remaining on the surface of the circuit portion. The method for removing the dielectric layer was a wet blast treatment, in which a polishing slurry solution (abrasive concentration: 14vol. %) obtained by dispersing an alumina abrasive of micropowder having a median particle size of 14 micron meter into water was shot on the surface through a slit nozzle of 90 mm in length and 2 mm in width as a high-speed water jet with the water pressure of 0.20 MPa to abrade and remove the unnecessary dielectric layer. After finishing the wet blast treatment, the etching resist was peeled off and the resultant was rinsed with water and dried to be the state shown in Figure 2 (c).

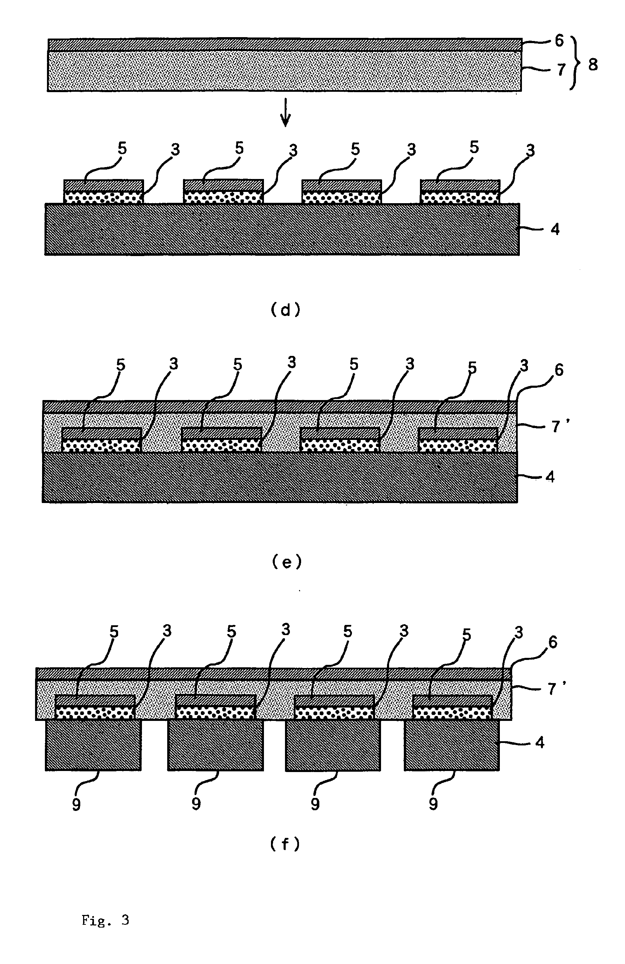

Gaps between the top electrodes of the capacitor layer forming material after finishing the removal of the dielectric layer described above, which gaps had been made deep by the removal of the exposing dielectric layer, are required to be filled. Then, as shown in Figure 3(d), to provide an insulating layer and a conductive layer on the surface of the capacitor layer forming material, a resin coated cooper foil 8, a semicured resin layer 7 of 80 micron meter in thickness is provided on one surface of a copper foil 6 was superposed on the capacitor layer forming material, and hot pressed under the heating condition at 180°C for 60 min. to obtain the state shown in Figure 3 (e) in which a copper foil layer 6 and an insulating layer 7' are laminated on the outer layer. Then, the second conductive layer 4 of the outer layer shown in Figure 3 (e) was etched to obtain bottom electrodes 9 in the state shown in Figure 3 (f). The etching factor of the bottom electrode was 6.2, it is understood that favorable etching was performed. The etching factor used in the present specification is, when h refers to the sectional height of a circuit and when with the approximation of the circuit cross-section shape being nearly trapezoid, L₁ refers to the top side length and L₂ refers to the bottom side length, a value calculated by 2h/ (L₁-L₂). Therefore, a larger value of the etching factor is judged that etching was performed in more favorable.

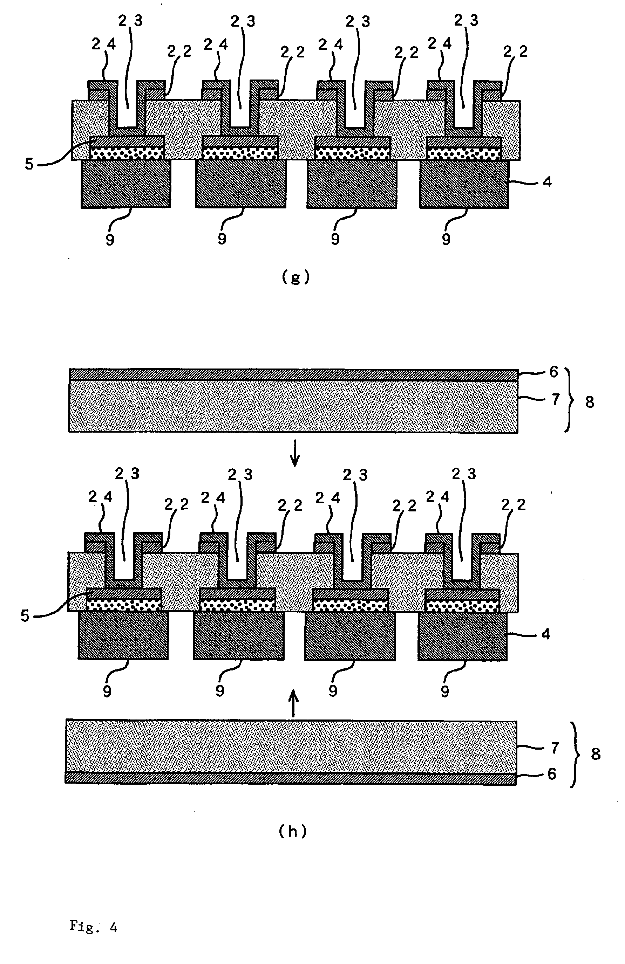

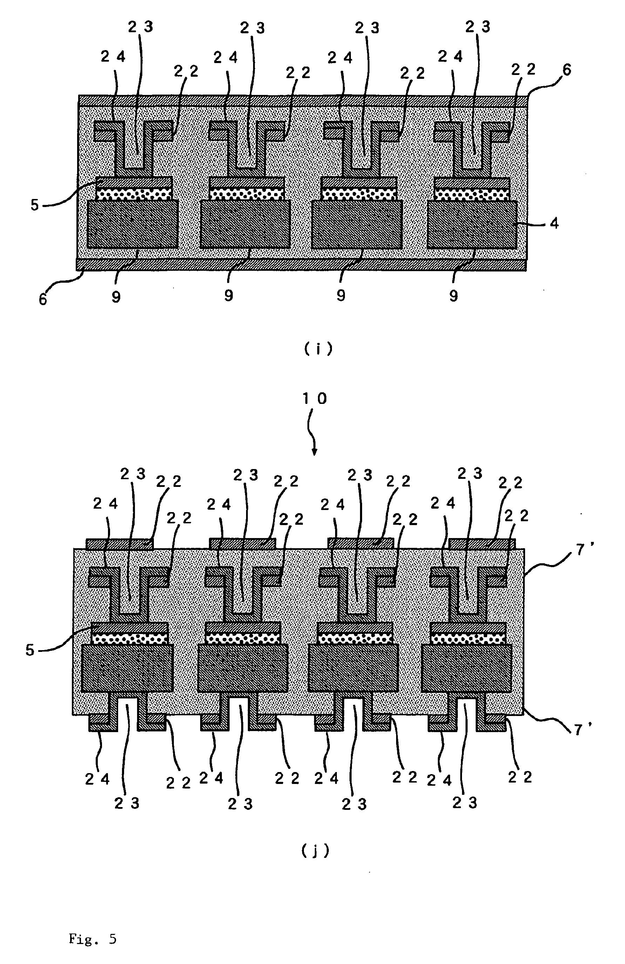

Next, for forming an outer layer circuit 22 and via holes 23 on the copper foil layer 6 located at the outer layer, a copper plated layer 24 was provided according to a popular method, and etched into the state of Figure 4(g). As shown in Figure 4(h), a resin coated copper foil 8 was superposed and hot pressed under the heating condition at 180°C for 60 min., and a copper foil layer 6 and an insulating layer 7' were laminated on the outer layer to make the state shown in Figure 5 (i) .

Then, for forming an outer layer circuit 22 and via holes 23 on the copper foil layer 6 located at the outer layer, a copper plated layer 24 was provided according to a popular method, and etched into the state of Figure 5 (j). The etching method and the via hole formation were performed according to popular ones. As described above, a printed wiring board 10 having the embedded capacitor circuit was manufactured.

### [Example 2]

In Example 2, manufacturing of a capacitor layer forming material and a printed wiring board having an embedded capacitor circuit was performed in similar manner to Example 1, but a nickel foil of 50 micron meter in thickness manufactured by the rolling method was used in place of the electrodepositednickel foil of Example 1. Therefore, duplicate description is avoided and just a rolled nickel foil will be described. The rolled nickel foil was made into a nickel foil by the rolling process by using a pure nickel ingot of not less than 99.9 wt% in purity. For use of the rolled nickel foil, in order to remove oil contents adhered in rolling process, the rolled nickel foil had been subjected to the alkali degreasing with a sodium hydroxide solution, the pickling treatment with a dilute sulfuric acid solution and the sufficient rinsing with water for cleaning. Then by similar manner as in Example 1, a capacitor layer forming material was manufactured, and further a printed wiring board having an embedded capacitor circuit was manufactured. Tensile strength and elongation as received and tensile strength and elongation after heating in vacuum at 400°C for 10 hrs was evaluated on the rolled nickel foil used here. The results are shown in Table 1.

A predetermined voltage was impartedon the capacitor layer forming material manufactured as described above to measure the interlayer dielectric strength, but no short-circuit phenomenon between the first conductive layer and the second conductive layer was found. To examine the adhesion between the second conductive layer and the dielectric layer, peel strength at the interface between the second conductive layer and the dielectric layer was measured. As a result, peel strength was 50 gf/cm. In the case of the electrode area of the top electrode of 1 mm², the average capacitance density exhibited a very favorable value of 217 nF/cm²; the dielectric loss was 2.7%; thus, it can be said that a favorable capacitor circuit having a favorable electric capacity and a low dielectric loss was obtained. Further, the etching factor of the bottom electrode of the embedded capacitor circuit was 6.1, and it is understood that a favorable etching was performed.

### [Example 3]

In Example 3, manufacturing of a capacitor layer forming material and a printed wiring board having an embedded capacitor circuit was performed in similar manner to Example 1, but a nickel-phosphorus alloy foil of 20 micron meter in thickness manufactured by the electrolysis method was used in place of the electrodeposited nickel foil of Example 1. Therefore, duplicate description is avoided and just manufacturing of a nickel-phosphorus alloy foil will be described.

### <Manufacturing of a nickel-phosphorus alloy foil>

A nickel-phosphorus alloy foil of 20 micron meter in thickness and phosphorus content of 0.3 wt% was manufactured by depositing a nickel-phosphorus alloy on a cathode electrode using the following electrolytic solution and electrolytic conditions followed by peeling off the deposited alloy.

| (A composition of a nickel-phosphorus electrolytic bath) | |
|---|---|
| NiSO₄.6H₂O: | 250 g/l |
| NiCl₂.6H₂O: | 40.39 g/l |
| H₃BO₃: | 19.78 g/l |
| H₃ PO₃ : | 3.0 g/l |

| (Electrolysis conditions) | |
|---|---|
| bath temperature: | 50°C |
| current density: | 20 A/dm² |
| stirring : | done |
| anode: | insoluble anode |
| cathode: | titanium plate |

Tensile strength and elongation as received and tensile strength and elongation after heating in vacuum at 400°C for 10 hrs was evaluated on the nickel-phosphorus alloy foil obtained by the electrolysis above. The results are shown in Table 1. Then, by similar manner as in Example 1, a capacitor layer forming material was manufactured, and a printed wiring board having an embedded capacitor circuit was manufactured.

A predetermined voltage wasimparted on the capacitor layer forming material manufactured as described above to measure the interlayer dielectric strength, but no short phenomenon between the first conductive layer and the second conductive layer was found. To examine the adhesion between the second conductive layer and the dielectric layer, peel strength at the interface between the second conductive layer and the dielectric layer was measured. As a result, peel strength was 14 gf/cm. In the case of the electrode area of the top electrode of 1 mm², the average capacitance density exhibited a very favorable value of 366 nF/cm² ; the dielectric loss was 1.1%; thus, it can be said that a favorable capacitor circuit having a favorable electric capacity and a low dielectric loss was obtained. Further, the etching factor of the bottom electrode of the embedded capacitor circuit was 6.3, and it is understood that a favorable etching was performed.

### [Example 4]

In Example 4, manufacturing of a capacitor layer forming material and a printed wiring board having an embedded capacitor circuit was performed in similar manner to Example 1, but a nickel-phosphorus alloy foil (phosphorus content: 0.3 wt%) of 50 micron meter in thickness manufactured by the rolling method was used in place of the electrodeposited nickel foil of Example 1. Therefore, duplicate description is avoided and a rolled nickel foil only will be described. The rolled nickel foil was made into a nickel-phosphorus alloy foil by the rolling process by using a nickel-phosphorus alloy ingot of 8 wt% in phosphorus content. For use of the rolled nickel-phosphorus alloy foil, in order to remove oil contents adhered in rolling process, the rolled nickel-phosphorus alloy foil had been subjected to the alkali degreasing with a sodium hydroxide solution, the pickling treatment with a dilute sulfuric acid solution and the sufficient rinsing with water for cleaning. Then, by similar manner as in Example 1, a capacitor layer forming material was manufactured, and further a printed wiring board having an embedded capacitor circuit was manufactured. Tensile strength and elongation as received and tensile strength and elongation after heating in vacuum at 400°C for 10 hrs was evaluated on the rolled nickel-phosphorus alloy foil used here. The results are shown in Table 1.

Apredeterminedvoltagewas imparted on the capacitor layer forming material manufactured as described above to measure the interlayer dielectric strength, but no short-circuit phenomenon between the first conductive layer and the second conductive layer was found. To examine the adhesion between the second conductive layer and the dielectric layer, peel strength at the interface between the second conductive layer and the dielectric layer was measured. As a result, peel strength was 15 gf/cm. In the case of the electrode area of the top electrode of 1 mm², the average capacitance density exhibited a very favorable value of 333 nF/cm²; the dielectric loss was 1.1%; thus, it can be said that a favorable capacitor circuit having a favorable electric capacity and a low dielectric loss was obtained. Further, the etching factor of the bottom electrode of the embedded capacitor circuit was 6.0, and it is understood that a favorable etching was performed.

### [Comparative Examples]

### [Comparative Example 1]

Comparative Example 1 described below is different from Example 1 only in the point that a second conductive layer in Example 1 was constituted of a conventional electrodeposited copper foil of 35 micron meter in thickness. Therefore, description of parts otherwise necessitating duplicate description is omitted to the utmost. Therefore, a capacitor layer forming material was manufactured by using an electrodeposited copper foil of 35 micron meter in thickness for forming a second conductive layer and forming a dielectric layer on one surface thereof by the sol-gel method as in Example 1. Then, at this stage, the interlayer dielectric strength measurement was conducted, but a short-circuit phenomenon occurred between the first conductive layer and the second conductive layer, so it was difficult to produce a capacitor layer forming material. Therefore, following manufacture of a printed wiring board having an embedded capacitor circuit was not performed. Tensile strength and elongation as received and tensile strength and elongation after heating in vacuum at 400°C for 10 hrs was evaluated on the electrodeposited copper foil used here. The results are shown in Table 1.

### [Comparative Example 2]

Comparative Example 2 described below is different from Example 1 only in the point that a composite foil in which a pure nickel layer of about 3 micron meter in thickness was formed on the electrodeposited copper foil of 35 micron meter in thickness was used as the second conductive layer of Example 1. Therefore, description of parts otherwise necessitating duplicate description is omitted to the utmost.

The composite foil used for forming the second conductive layer was manufactured by providing a pure nickel layer of about 3 micron meter in thickness on both surfaces of the electrodeposited copper foil of 35 micron meter in thickness by the electrolytic plating method. The electrolytic solution and the electrolytic conditions used to form the pure nickel layer were similar to Example 1. Tensile strength and elongation as received and tensile strength and elongation after heating in vacuum at 400°C for 10 hrs was evaluated on the composite foil used here. The results are shown in Table 1.

A dielectric layer was formed by the sol-gel method as in Example 1, and a capacitor layer forming material in which a first conductive layer and a second conductive layer are provided on both surfaces of the dielectric layer was manufactured. At this stage, the interlayer dielectric strength measurement was conducted, but a short-circuit phenomenon occurred between the first conductive layer and the second conductive layer, and the product yield was 60%. To examine the adhesion between the second conductive layer and the dielectric layer, peel strength at the interface between the second conductive layer and the dielectric layer was measured. As a result, peel strength was 10 gf /cm, which is a certain level of peel strength but lower than those of the above examples.

A printed wiring board having an embedded capacitor was manufactured by similar manner as in Example 1 by using the capacitor layer forming material manufactured in Comparative Example 2. As a result, in the case of the electrode area of the top electrode of 1 mm², the average capacitance density was 265 nF/cm², and the dielectric loss was 6.8% . As compared with the examples, the capacitance density and the dielectric loss are both inferior. Further, the etching performance of the bottom electrode of the embedded capacitor circuit by observation of the circuit cross-section exhibited the state that the side etching of the copper layer underneath the pure nickel layer progressed and the pure nickel layer widely remained and overhung due to a faster rate of etching of the copper layer underneath the pure nickel layer, so the measurement of the exact etching factor was difficult, but the factor was 3.2 if forcibly measured, which cannot be said to be a favorable etching performance.

### [Comparative Example 3]

Comparative Example 3 described below is different from Example 1 only in the point that a composite foil in which a nickel-phosphorus alloy layer (phosphorus content: 8 wt%) of about 3 micron meter in thickness was formed on the electrodeposited copper foil of 35 micron meter in thickness was used as the second conductive layer of Example 1. Therefore, description of parts otherwise necessitating duplicate description is omitted to the utmost.

The composite foil used for forming the second conductive layer was manufactured by providing a nickel-phosphorus alloy layer of about 3 micron meter in thickness on both surfaces of the electrodeposited copper foil of 35 micron meter in thickness by the electrolytic plating method. The following electrolytic solution and electrolytic conditions was used to form the nickel-phosphorus alloy layer. Tensile strength and elongation as received and tensile strength and elongation after heating in vacuum at 400°C for 10 hrs was evaluated on the rolled nickel foil used here. The results are shown in Table 1.

| (A composition of a nickel-phosphorus electrolytic bath) | |
|---|---|
| NiSO₄·6H₂O: | 250 g/l |
| NiCl₂·6H20: | 40.39 g/l |
| H₃BO₃: | 19.78 g/l |
| H₃PO₄ : | 26.46 g/l |

| (Electrolysis conditions) | |
|---|---|
| bath temperature: | 50°C |
| current density | 20 A/dm² |
| anode: | anodic polarization of copper foils itself |
| cathode: | nickel plate |

A dielectric layer was formed by the sol-gel method as in Example 1, and a capacitor layer forming material in which a first conductive layer and a second conductive layer are provided on both surfaces of the dielectric layer was manufactured. At this stage, the interlayer dielectric strength measurement was conducted, and a short-circuit phenomenon between the first conductive layer and the second conductive layer was not found. To examine the adhesion between the second conductive layer and the dielectric layer, peel strength at the interface between the second conductive layer and the dielectric layer was measured. As a result, peel strength was 2 gf/cm, which is very much lower than those of the above examples.

A printed wiring board having an embedded capacitor was manufactured by similar manner as in Example 1 by using the capacitor layer forming material manufactured in Comparative Example 3. As a result, in the case of the electrode area of the top electrode of 1 mm², the average capacitance density was 370 nF/cm², and the dielectric loss was 2.0%. As compared with the examples, the electric capacity and the dielectric loss are very favorable. The etching performance of the bottom electrode of the embedded capacitor circuit by observation of the circuit cross-section exhibited the state that the side etching of the copper layer underneath the pure nickel layer progressed and the pure nickel layer widely remained and overhung due to a faster rate of etching of the copper layer underneath the pure nickel layer, so the measurement of the exact etching factor was difficult, but the factorwas 3.2 if forciblymeasured, which cannot be said tobe a favorable etching performance.

**[Table 1]**

| Example or Comparative Example | As received | | After heating *1 | |
|---|---|---|---|---|
| | Tensile strength (kgf/mm²) | Elongation (%) | Tensile str ength (kgf/mm²) | Elongation (%) |
| Example 1 | 84.3 | 3.7 | 59.3 | 5.5 |
| Example 2 | 88.3 | 4.5 | 57.1 | 4.6 |
| Example 3 | 90.1 | 3.2 | 65.5 | 4.0 |
| Example 4 | 94.5 | 4.2 | 63.4 | 4.2 |
| Comparative Example 1 | 51.0 | 6.3 | 20.6 | 2.5 |
| Comparative Example 2 | 54.0 | 6.1 | 33.3 | 15.9 |
| Comparative Example 3 | 75.2 | 3.5 | 39.0 | 3.3 |

| | | | | |
|---|---|---|---|---|
| *1: at 400°C for 10 hrs, in vacuum | | | | |

### <Comparison of Examples and Comparative Examples>

First, views on Comparative Examples will be described. In Comparative Example 1 where a conventional electrodeposited copper foil is used as a second conductive layer, in the forming stage of a dielectric layer by the sol-gel method, the second conductive layer suffers a large heating damage and exhibits a remarkable physical damage including tensile strength. Further, manufacturing of a capacitor layer forming material is difficult, and in industrial view, use of the capacitor layer forming material may be impossible.

In the case where a composite copper foil in which a pure nickel layer is provided on a copper foil is used as a second conductive layer, tensile strength and elongation after heating at 400°C for 10 hrs has no problem. And when the second conductive layer is used for a capacitor layer forming material, the average capacitance density as a capacitor has no problem also. But the adhesion between the second conductive layer and the dielectric layer is lower than that of Examples and the dielectric loss may be comparatively large.

Further, in the case where a composite copper foil in which a nickel-phosphorus alloy layer is provided on a copper foil is used as a second conductive layer, tensile strength and elongation after heating at 400°C for 10 hrs has no problem, and when the second conductive layer is used for a capacitor layer forming material, the average capacitance density as a capacitor has no problem, but the adhesion between the second conductive layer and a dielectric layer is remarkably low as compared with Examples. Moreover, the etching factors of bottom electrodes of Comparative Examples cannot be said to have favorable values. Accordingly, it is clear that Comparative Examples are inferior in the maintaining performance of the physical strength of the second conductive layer, the adhesion between the second conductive layer and the dielectric layer, the average capacitance density and dielectric loss as a capacitor in the capacitor layer forming material, and the etching factor, and lack the total balance among these qualities .

In contrast, in Examples 1 to 4, in the case where a nickel foil or nickel-phosphorus alloy foil is used for constituting a second conductive layer of a capacitor layer forming material, a capacitor layer forming material excellent in the total balance can be obtained. Because that the nickel foil or nickel-phosphorus alloy foil constituting the second conductive layer has a very favorable tensile strength and elongation after heating at 400°C for 10 hrs, when processed into a capacitor layer forming material, the short-circuit phenomenon between the first conductive layer and the second conductive layer does not occur, and also that the average capacitance density and the dielectric loss exhibit values having practically no trouble. Additionally, even when the capacitor layer forming material is processed up to a printed wiring board having an embedded capacitor, the etching factor of the bottom electrode is remarkably favorable, and a high-quality printed wiring board can be obtained without any problem.

### Industrial Applicability

The capacitor layer forming material according to the present invention is, since a nickel foil or nickel-phosphorus alloy foil excellent in thermal resistance is used as the second conductive layer constituting the bottom electrode, suitable especially for manufacture of a multi-layer printed wiring board using a fluorine-contained resin substrate or liquid crystal polymer substrate. Even when the capacitor layer forming material repeatedly undergoes the hot pressing in the range from 300°C to 400°C in manufacturing of a printed wiring board using these substrates, the bottom electrode shape generates no abnormality even after the capacitor circuit shape is formed, and the bottom electrode has the resistance against the expansion and contraction behavior of surrounding materials by heating. Since the nickel foil and nickel-phosphorus alloy foil have such an excellent thermal resistance, there arises no problem even if they are subjected to the severe thermal history when the dielectric layer is formed on the nickel foil or nickel-phosphorus alloy foil by the sol-gel method.

## Claims

1. A capacitor layer forming material for a printed wiring board comprising a first conductive layer used for forming an top electrode, a second conductive layer used for forming a bottom electrode and a dielectric layer between the first and second conductive layers, which is **characterized in that** the second conductive layer is a nickel layer or a nickel alloy layer.

2. The capacitor layer forming material according to claim 1, wherein the nickel layer or the nickel alloy layer as the second conductive layer has a thickness of 10 micron meter to 100 micron meter.

3. The capacitor layer forming material according to claim 1 or 2, wherein a nickel foil or a nickel alloy foil manufactured by the rolling method or the electrolysis method is used for the second conductive layer.

4. The capacitor layer forming material according to any one of claims 1 to 3, wherein the dielectric layer is formed by the sol-gel method on the nickel layer or the nickel alloy layer constituting the second conductive layer.

5. The capacitor layer forming material according to any one of claims 1 to 4, wherein the nickel alloy layer is formed of a nickel-phosphorus alloy or a nickel-cobalt alloy.

6. A printed wiring board having an embedded capacitor layer obtained by using the capacitor layer forming material according to any one of claims 1 to 5.
